# EUROPÄISCHE PATENTANMELDUNG

(11) **EP 0 862 064 A2**
(43) Veröffentlichungstag der Anmeldung: **02.09.1998**
(21) Anmeldenummer: 98890034.6
(22) Anmeldetag: 12.02.1998
(51) Int. Cl.: G01R 33/09, H01R 4/10

(54) **Verfahren zur Herstellung eines Magnetfeldsensors und nach diesem Verfahren hergestellter Sensor**

(30) Priorität: 26.02.1997 AT 323/97; 03.02.1998 AT 183/98
(71) Anmelder: Securiton General Control Systems Gesellschaft m.b.H., 1010 Wien (AT)
(72) Erfinder: Hauser, Hans, Dr., 1160 Wien (AT); Nicolics, Johann, Dr., 1040 Wien (AT); Bruggraber, Horst, Dipl.-Ing., 8665 Langenwang (AT); Newald, Herbert, Dipl.-Ing., 1090 Wien (AT)
(74) Vertreter: Atzwanger, Richard, Dipl.-Ing. Patentanwalt

(57) **Zusammenfassung**

Verfahren zur Herstellung eines Magnetfeldsensors, dessen Sensorelement durch mindestens ein aus einem amorphen oder nanokristallinen, ferromagnetischen Material bestehendes Drahtstück (4), dessen elektrischer Widerstand magnetfeldabhängig ist, gebildet ist, wobei das Drahtstück (4) mit elektrisch leitenden Anschlüssen aus einem nicht ferromagnetischen Metall versehen wird. Dabei werden die Enden des mindestens einen Drahtstückes (4) in zwei voneinander im Abstand befindliche elektrische Leiter (21, 31) aus einem nicht ferromagnetischen Metall, insbesondere aus Kupfer, eingepreßt (Fig. 1).

## Beschreibung

Die gegenständliche Erfindung betrifft ein Verfahren zur Herstellung eines Magnetfeldsensors, dessen Sensorelement durch mindestens ein aus einem amorphen oder nanokristallinen, ferromagnetischen Material bestehendes Drahtstück, dessen elektrischer Widerstand magnetfeldabhängig ist, gebildet ist, wobei das Drahtstück mit elektrisch leitenden Anschlüssen aus einem nicht ferromagnetischen Metall versehen wird. Die gegenständliche Erfindung betrifft weiters nach diesem Verfahren hergestellte Magnetfeldsensoren.

Bekannte Magnetfeldsensoren enthalten ein aus einem amorphen, ferromagnetischen Material hergestelltes Drahtstück, dessen elektrischer Widerstand magnetfeldabhängig ist. Aufgrund dieser Eigenschaft kann durch Messung des das Sensorelement durchfließenden Stromes die Stärke eines Magnetfeldes erfaßt werden. Derartige Magnetfeldsensoren werden z.B. zur Abtastung von magnetisch codierten Datenträgern, welche eine Mehrzahl von eng nebeneinander liegenden, magnetischen Dipolen aufweisen, verwendet. Dabei besteht das Erfordernis, die hierdurch erzeugten einzelnen Magnetfelder jeweils für sich erfassen zu können, um hierdurch die Information des Datenträgers aufnehmen zu können. Da somit die einzelnen Magnetfelder sehr eng aneinander liegen, besteht das Erfordernis, das Sensorelement mit sehr geringen Längen, z.B. in der Größenordnung von etwa 100 µm, auszubilden, um hierdurch die erwünschte örtliche Auflösung zu erzielen.

Bei der Herstellung von derartigen Magnetfeldsensoren besteht jedoch die Schwierigkeit, daß aus einem amorphen oder nanokristallinen Drahtmaterial hergestellte Sensorelemente mit derart geringen Abmessungen einer Verbindung mit den elektrischen Anschlüssen durch Löten nicht oder nur erschwert zugänglich sind, wodurch Magnetfeldsensoren, welche sehr geringe wirksame Längen aufweisen, mittels herkömmlicher Methoden nicht herstellbar sind.

Aus der JP 08-323 479A ist es bekannt, aus einem amorphen Material bestehende Sensorelemente mittels Widerstandsschweißung mit den elektrischen Anschlüssen zu verbinden. Hierdurch wird jedoch der Nachteil bedingt, daß durch eine Widerstandsschweißung die amorphe Struktur der Sensorelemente zerstört bzw. beschädigt wird, wodurch die Magnetfeldabhängigkeit der Sensorelemente zerstört bzw. beeinflußt wird.

Der gegenständlichen Erfindung liegt demnach die Aufgabe zugrunde, ein Verfahren zu schaffen, durch welches Magnetfeldsensoren mit sehr geringen wirksamen Längen hergestellt werden können. Dies wird erfindungsgemäß dadurch erzielt, daß die Enden des mindestens einen Drahtstückes in zwei voneinander im Abstand befindliche elektrische Leiter aus einem nicht ferromagnetischen Metall, insbesondere aus Kupfer, eingepreßt werden. Hierdurch ist durch den Abstand der beiden elektrischen Leiter voneinander die wirksame Länge des Sensorelementes bestimmt.

Vorzugsweise wird das mindestens eine aus einem amorphen oder nanokristallinen, ferromagnetischen Material bestehende Drahtstück nach dem Einpressen in die elektrischen Leiter aus einem nicht ferromagnetischen Metall mit diesen zusätzlich durch Schweißung, insbesondere mittels Hochenergiestrahlen, z. B. Laserstrahlen, verbunden. Weiters ist es zweckmäßig, nach dem Einpressen des mindestens einen Drahtstückes in die beiden elektrischen Leiter aus einem nicht ferromagnetischen Metall dessen Enden mittels Hochenergiestrahlen, insbesondere mittels Laserstrahlen, oder durch Trennschweißung, abzutrennen. Der Grund hierfür liegt darin, daß durch diese Enden eine Beeinflussung der magnetischen Felder bedingt wird, wodurch das Ergebnis der Erfassung verfälscht werden kann.

Nach einer bevorzugten Ausführungsform werden die beiden Enden eines geraden, aus einem amorphen oder nanokristallinen, ferromagnetischen Material hergestellten Drahtstückes in zwei voneinander im Abstand befindliche elektrische Leiter aus einem nicht ferromagnetischen Metall eingepreßt. Alternativ dazu wird ein aus einem amorphen oder nanokristallinen, ferromagnetischen Material hergestelltes Drahtstück angenähert U-förmig gebogen und werden dessen beide Schenkel auf eine Platte aus elektrisch isolierendem Material, deren beiden Seiten mit Beschichtungen aus einem elektrisch leitenden, nicht ferromagnetischen Metall, insbesondere aus Kupfer, versehen sind, aufgeschoben und in diese Beschichtungen eingepreßt.
Durch beide diese Verfahren können sehr kleine wirksame Längen des Sensorelementes hergestellt werden.

Nach einem weiteren erfindungsgemäßen Verfahren ist das aus einem amorphen oder nanokristallinen, ferromagnetischen Material hergestellte Drahtstück mäanderförmig ausgebildet, wobei dessen beiden Enden in voneinander elektrisch getrennte Leiter aus einem nicht ferromagnetischen Metall eingepreßt werden. Weiters können die Enden von zwei aus einem amorphen oder nanokristallinen, ferromagnetischen Material hergestellten Drahtstücken, welche miteinander einen Winkel, insbesondere einen Winkel von 90° einschließen, in voneinander im Abstand befindliche elektrische Leiter aus einem nicht ferromagnetischen Metall, insbesondere aus Kupfer, eingepreßt werden. Hierdurch werden Magnetfeldsensoren erzeugt, durch welche bei einer geradlinigen Bewegung ohne Veränderung der Winkellage des Sensors unterschiedlich ausgerichtete Magnetfelder erfaßt werden können.

Erfindungsgemäße Verfahren sind nachstehend anhand von in der Zeichnung dargestellten Ausführungsbeispielen näher erläutert. Es zeigen:
- Fig. 1: einen Magnetfeldsensor, welcher nach einem ersten erfindungsgemäßen Verfahren hergestellt ist,
- die Fig 1a und 1b: zwei gegenüber dem Magnetfeldsensor gemäß Fig. 1 abgeänderte Magnetfeldsensoren, welche nach dem ersten erfindungsgemäßen Verfahren hergestellt sind, und
- Fig. 2: einen Magnetfelsensor, welcher nach einem zweiten erfindungsgemäßen Verfahren hergestellt ist.

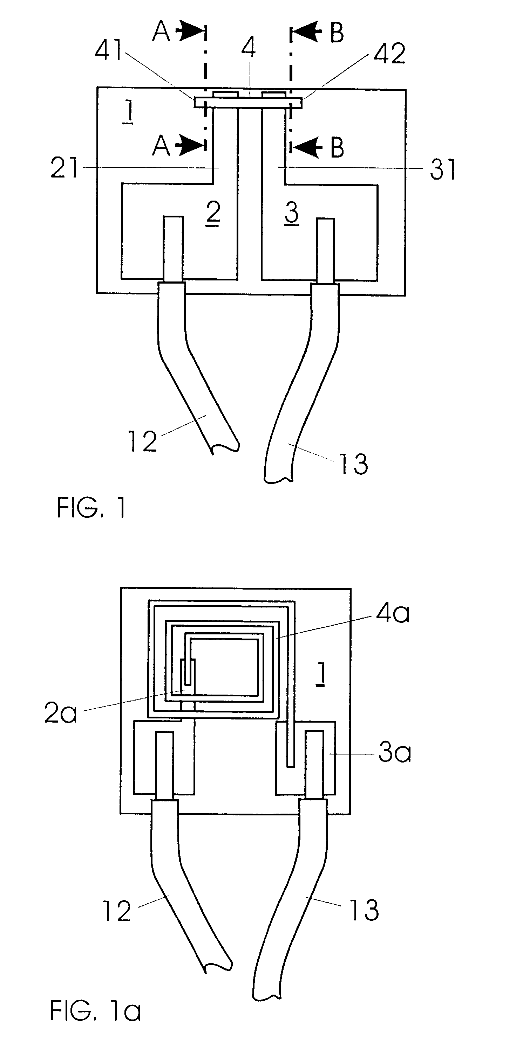

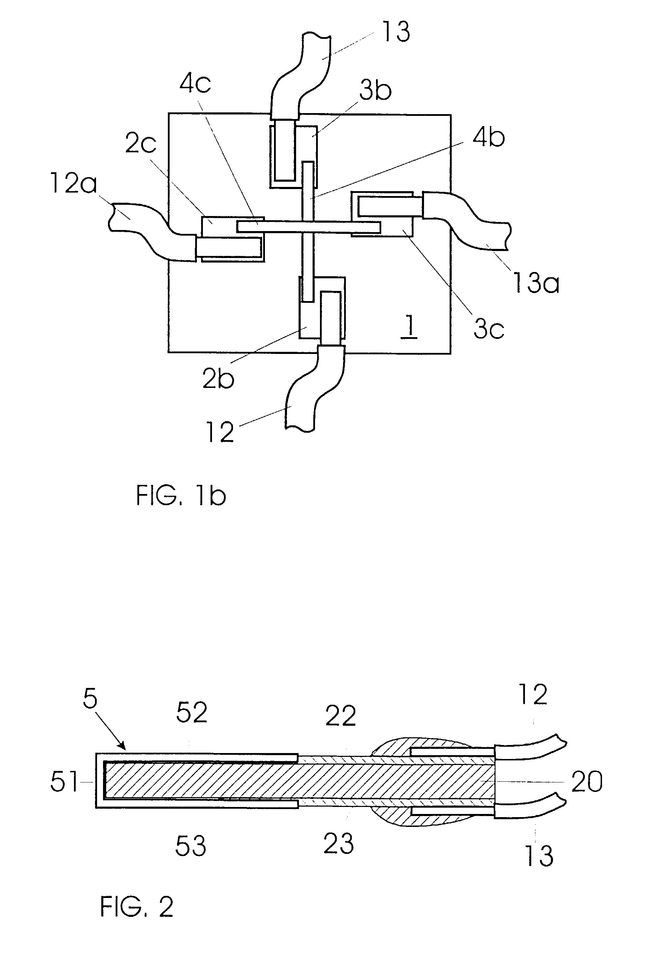

Anhand der Fig. 1 ist ein erstes erfindungsgemäßes Herstellungsverfahren erläutert:

Eine aus glasfaserverstärktem Epoxidharz gefertige Platte 1, welche eine elektrisch leitende Beschichtung aus einem nicht ferromagnetischen Metall, wie Kupfer, mit einer Dicke von 35 µm aufweist, wird mittels eines bekannten ätztechnischen Verfahrens mit zwei voneinander getrennten, elektrisch leitenden Kontaktflächen 2 und 3 ausgebildet. An die Kontaktflächen 2 und 3 werden in herkömmlicher Weise, z.B. durch Lötung, elektrische Leiter 12 und 13 angeschlossen. Die Kontaktflächen 2 und 3 sind mit zwei Fahnen 21 und 31 ausgebildet, welche sich voneinander in einem Abstand von etwa 100 µm befinden. In diese Fahnen 21 und 31 wird ein aus einem amorphen oder nanokristallinen, ferromagnetischen Material hergestelltes Drahtstück 4 mit einer Dicke von etwa 35 µm eingepreßt, wodurch es mit den Fahnen 21 und 31 mechanisch und elektrisch verbunden wird. Ein Einpressen ist deshalb möglich, da das nicht ferromagnetische Metall wesentlich weicher als dasjenige Material ist, aus welchem das Drahtstück 4 hergestellt ist.
In der Folge werden die über die Fahnen abstehenden Enden 41 und 42 des Drahtstückes 4 mittels Laserstrahlung oder Trennschweißung längs der Linien A - A und B - B abgetrennt. Dies ist deshalb erforderlich, da durch diese Enden das magnetische Feld beeinflußt wird, wodurch die Messung verfälscht wird. Die wirksame Länge des durch das Drahtstück 4 gebildeten Sensorelementes wird durch den Abstand der beiden Fahnen 21 und 31 voneinander bestimmt.

Durch dieses Verfahren können somit Magnetfeldsensoren hergestellt werden, bei welchen die wirksamen Längen der Sensorelemente sehr geringe Werte aufweisen, wodurch auch durch eng nebeneinander befindliche magnetische Dipole erzeugte Magnetfelder erfaßt werden können. Hierdurch wird z.B. eine hohe Auflösung eines magnetisch codierten Datenträgers ermöglicht. Ebenso können mit einem derartigen Magnetfeldsensor die Drehwinkel von Zahnrädern oder von Schrittmotoren erfaßt werden.

In Fig. 1a ist ein Magnetfeldsensor dargestellt, bei welchem das Sensorelement eine andere Ausbildung aufweist. Auch dabei befinden sich auf einer Trägerplatte 1 elektrische Kontaktflächen 2a und 3a aus nicht ferromagnetischen, metallischen Beschichtungen, insbesondere aus Kupfer, an welche Leiter 12 und 13 angelötet sind. In diese beiden Kontaktflächen 2a und 3a sind die beiden Enden eines mäanderförmig ausgebildeten, aus einem amorphen oder nanokristallinen, ferromagnetischen Material hergestellten Sensorelementes 4a eingepreßt, wodurch sie mit diesen mechanisch und elektrisch verbunden werden. Dabei muß einer der Anschlüsse, welcher das Sensorelement 4a kreuzt, gegenüber diesem isoliert sein. Durch diese Struktur des Sensorelementes 4a wird dessen wirksame Länge mehrfach vergrößert, ohne daß hierdurch die tatsächliche Länge des Sensorelementes 4a maßgeblich vergrößert wird. Hierdurch wird eine wesentlich erhöhte Empfindlichkeit des Sensorelementes erzielt.

Zudem können durch ein derartiges Sensorelement durch eine geradlinige Bewegung unterschiedlich ausgerichtete Magnetfelder erfaßt werden, ohne daß es hiezu einer Änderung in der Winkellage des Magnetfeldsensors bedarf. Hierdurch können somit bei der Bewegung eines Magnetfeldsensors in einer Richtung unterschiedlich ausgerichtete Magnetfelder erfaßt werden.

In Fig. 1b ist ein Magnetfeldsensor dargestellt, welcher mit zwei Sensorelementen ausbildet ist. Dabei befinden sich auf einer Trägerplatte 1 vier elektrische Kontaktflächen 2b, 3b, 2c und 3c aus einer nicht ferromagnetischen, metallischen Beschichtung, insbesondere aus Kupfer, an welche einerseits die elektrischen Anschlußleitungen 12 und 13 sowie 12a und 13a angelötet sind und in welche andererseits die jeweiligen Enden von zwei aus einem amorphen oder nanokristallinen, ferromagnetischen Material gefertigten Sensoren 4b und 4c, welche einander rechtwinkelig kreuzen, eingepreßt sind. Durch einen derartigen Magnetfeldsensor können gleichfalls richtungsunabhängige Messungen vorgenommen werden bzw. können zweidimensionale Erfassungen von Magnetfeldern erfolgen.

Anhand der Fig. 2 ist ein zweites Herstellungsverfahren für einen Magnetfeldsensor erläutert:

Auf eine Platte 20 aus einem elektrisch nicht leitenden Material, welche auf der Oberseite und auf der Unterseite mit elektrisch leitenden Beschichtungen 22 und 23 aus einem nicht ferromagnetischen Metall, z.B. aus Kupfer, versehen ist, wird dadurch ein angenähert U-förmig gebogenes Sensorelement 5 aus einem amorphen oder nanokristallinen, ferromagnetischen Material aufgebracht, daß dessen beiden Schenkel 52 und 53 in die Beschichtungen 22 und 23 eingepreßt werden, wodurch es mit der Trägerplatte 20 mechanisch und elektrisch verbunden wird. Bei durch sehr kleine magnetische Dipole erzeugten Magnetfeldern entspricht dabei die Länge des Steges 51 des Sensorelementes der Länge der Dipole und ist die wirksame Länge des Sensorelementes durch die Länge dieses Steges 51 bestimmt.

Das Einpressen der aus einem amorphen oder nanokristallinen, ferromagnetischen Drahtmaterial hergestellten Sensorelemente in die nicht ferromagnetischen, metallischen Kontaktflächen kann z.B. mit einem polierten Plättchen aus Aluminiumoxidkeramik erfolgen.
Durch das Abtrennen der in die metallischen Kontaktflächen eingepreßten Enden der Drahtstücke mittels Hochenergiestrahlen oder durch Trennschweißung wird deshalb keine Schädigung der Struktur der Drahtstücke bedingt, da durch die Anschlußfahnen eine gute Ableitung der Wärme erfolgt.
Derart hergestellte Magnetfeldsensoren können auch in elektrische Schaltungen integriert werden.

Die Erfindung bezieht sich auch auf nach diesen Verfahren hergestellte Magnetfeldsensoren.

## Patentansprüche

1. Verfahren zur Herstellung eines Magnetfeldsensors, dessen Sensorelement durch mindestens ein aus einem amorphen oder nanokristallinen, ferromagnetischen Material bestehendes Drahtstück [4], dessen elektrischer Widerstand magnetfeldabhängig ist, gebildet ist, wobei das Drahtstück [4] mit elektrischen Anschlüssen aus einem nicht ferromagnetischen Metall versehen wird, dadurch gekennzeichnet, daß die Enden des mindestens einen Drahtstückes [4] in zwei voneinander im Abstand befindliche elektrische Leiter [21, 31] aus einem nicht ferromagnetischen Metall, insbesondere aus Kupfer, eingepreßt werden [Fig. 1].

2. Verfahren nach Patentanspruch 1, dadurch gekennzeichnet, daß das mindestens eine aus einem amorphen oder nanokristallinen, ferromagnetischen Material bestehende Drahtstück [4] nach dem Einpressen in die elektrischen Leiter [21, 31] aus einem nicht ferromagnetischen Metall mit diesen zusätzlich durch Schweißung, insbesondere mittels Hochenergiestrahlen, z. B. Laserstrahlen, verbunden wird.

3. Verfahren nach einem der Patentansprüche 1 und 2, dadurch gekennzeichnet, daß nach dem Einpressen des mindestens einen aus einem amorphen oder nanokristallinen, ferromagnetischen Material bestehenden Drahtstückes [4] in die beiden elektrischen Leiter [21, 31] aus einem nicht ferromagnetischen Metall dessen Enden [41, 42] mittels Hochenergiestrahlen, insbesondere mittels Laserstrahlen, abgetrennt werden.

4. Verfahren nach einem der Patentansprüche 1 bis 2, dadurch gekennzeichnet, daß nach dem Einpressen des mindestens einen aus einem amorphen oder nanokristallinen, ferromagnetischen Material bestehenden Drahtstückes [4] in die beiden elektrischen Leiter [21, 31] aus einem nicht ferromagnetischen Metall dessen Enden [41, 42] mittels Trennschweißung abgetrennt werden.

5. Verfahren nach einem der Patentansprüche 1 bis 4, dadurch gekennzeichnet, daß die beiden Enden eines geraden, aus einem amorphen oder nanokristallinen, ferromagnetischem Material hergestellten Drahtstückes [4] in zwei voneinander im Abstand befindliche elektrische Leiter [21, 31] aus einem nicht ferromagnetischen Metall eingepreßt werden [Fig. 1].

6. Verfahren nach einem der Patentansprüche 1 bis 4, dadurch gekennzeichnet, daß ein aus einem amorphen oder nanokristallinen, ferromagnetischem Material hergestelltes Drahtstück [5] angenähert U-förmig gebogen wird und daß dessen beide Schenkel [52, 53] auf eine Platte [20] aus elektrisch isolierendem Material, deren beiden Seiten mit Beschichtungen [22, 23] aus einem elektrisch leitenden, nicht ferromagnetischen Metall, insbesondere aus Kupfer, versehen sind, aufgeschoben und in diese Beschichtungen [22, 23] eingepreßt werden [Fig. 2].

7. Verfahren nach einem der Patentansprüche 1 bis 4, dadurch gekennzeichnet, daß das aus einem amorphen oder nanokristallinen, ferromagnetischen Material hergestellte Drahtstück [4a] mäanderförmig ausgebildet ist, wobei dessen beiden Enden in voneinander elektrisch getrennte Leiter [2a, 3a] aus einem nicht ferromagnetischen Metall eingepreßt werden [Fig. 1a].

8. Verfahren nach einem der Patentansprüche 1 bis 4, dadurch gekennzeichnet, daß die Enden von zwei aus einem amorphen oder nanokristallinen, ferromagnetischen Material hergestellten Drahtstücken [4b, 4c], welche miteinander einen Winkel, insbesondere einen Winkel von 90° einschließen, in voneinander im Abstand befindliche elektrische Leiter [2b, 3b, 2c, 3a] aus einem nicht ferromagnetischen Metall, insbesondere aus Kupfer, eingepreßt werden [Fig. 1b].

9. Magnetfeldsensor, welcher nach einem der Verfahren nach den Patentansprüchen 1 bis 8 hergestellt ist.
